# EUROPEAN PATENT APPLICATION

(11) **EP 4 803 941 A2**
(43) Date of publication of application: **09.09.2026**
(21) Application number: 26184942.6
(22) Date of filing: 31.03.2023
(51) Int. Cl.: G02B 6/12

(54) **SEMICONDUCTOR STRUCTURE FOR INHIBITING ELECTRICAL CROSS-TALK**

(30) Priority: 31.03.2022 GB 202204747
(62) Document number(s) of the earlier application(s) in accordance with Art. 76 EPC: 23717856.1 / 4 500 243
(71) Applicant: SMART Photonics Holding B.V., 5656 AE Eindhoven (NL)
(72) Inventor: TIEBOT, Paul, 5656 AE Eindhoven (NL); MILLÁN-MEJÍA, Alonso Jesús, 5656 AE Eindhoven (NL); AUGUSTIN, Ludovicus Marie, 5656 AE Eindhoven (NL); TESSEMA, Netsanet, 5656 AE Eindhoven (NL)
(74) Representative: EIP

(57) **Abstract**

A semiconductor structure for a photonic integrated circuit is provided. The semiconductor structure comprises a substrate, and, on the substrate: a first waveguide, and an electrically-conductive first layer in contact with the first waveguide and between the substrate and the waveguide; a second waveguide, and an electrically-conductive second layer in contact with the second waveguide and between the substrate and the waveguide; an active component optically coupled to the second waveguide; and an electrically resistive material having an electrical resistivity higher than the first waveguide and being arranged to inhibit flow of electricity between the first electrically-conductive layer and the active component; wherein at least one of the first waveguide and the second waveguide comprise a respective facet in contact with the electrically resistive material and intersecting the light propagation axis non-perpendicularly. A photonic integrated circuit comprising the semiconductor structure is also provided.

## Description

### Background

Semiconductor structures can be used in photonic integrated circuits (PICs) to perform various functions. Semiconductor structures for PICs may include passive components and active components for controlling the propagation of light. It is desirable also to control the flow of electricity in a PIC.

### Brief Description of the Drawings

Figure 1 illustrates schematically a side cross-section of a first semiconductor structure according to examples;
Figure 2a is a first graph showing reflectance as a function of wavelength of electrically resistive material within the first semiconductor structure according to examples;
Figure 2b is a second graph showing reflectance as a function of wavelength of electrically resistive material within the first semiconductor structure according to examples;
Figure 3 illustrates schematically a plan cross-section of the first semiconductor structure according to examples;
Figure 4 illustrates part of a method of manufacturing a semiconductor structure according to examples;
Figure 5a-5h each illustrate schematically examples of side cross sections of a semiconductor structure at various stages during manufacture according to examples;
Figure 6 illustrates schematically a side cross-section of a second semiconductor structure according to examples; and
Figure 7 illustrates schematically a plan cross-section of a third semiconductor structure according to examples.
Figures 8a-c illustrate schematically plan views of a fourth, fifth, and sixth semiconductor structure, respectively, according to examples.
Figures 9a-c illustrate schematically plan views of a seventh, eighth and ninth semiconductor structure, respectively, according to examples.
Figures 10a-c illustrate schematically plan views of a tenth, eleventh and twelfth semiconductor structure, respectively, according to examples.
Figure 11 illustrates schematically a plan view of a thirteenth semiconductor structure according to examples.

### Detailed Description

Examples described herein relate to a semiconductor structure for a PIC. More specifically, examples described herein relate to a semiconductor structure comprising electrically resistive material which inhibits electrical cross-talk between a waveguide and an active component.

If there is a path for electricity to flow between the waveguide and the active component, the operation of the active component can be affected. For example, the waveguide can carry electrical signals to the active component which interfere with the operation of the active component. For example, such unwanted electrical signals originate from other components of the PIC (for example, other active components) to which the wave guide is connected.

If there is a path for electricity to flow between the waveguide and the active component, the operation of other components of the PIC can be affected. For example, electrical signals from the active component are carried by the waveguide to other components of the PIC. The operation of those other components is affected by the electrical signals from the active component, for example.

Such problems can be mitigated or avoided by inhibiting the flow of electricity between the waveguide and the active component. As referred to herein, inhibiting the flow of electricity can be considered as significantly reducing the flow of electricity. For example, inhibiting the flow of electricity is reducing the flow of electricity between the waveguide and the active component by at least an order of magnitude (so, the current is reduced by a factor of 10). Inhibiting the flow of electricity in some examples is blocking or preventing the flow of current between the waveguide and the active component entirely. For example, inhibiting the flow of electricity includes electrically isolating the waveguide and the active component from one another. Electricity can flow between the active component and layers of the semiconductor structure other than the waveguide. For example, electricity flows between the active component and n-doped and/or p-doped semiconductor layers that are in contact with the waveguide.

In some examples, there are arrangements in which the active component is aligned with the waveguide such that light propagates between the waveguide and active component without a change in the general direction of light propagation. For example, the active component is at a similar distance from a substrate layer of the semiconductor structure. For example, a surface of the waveguide and a surface of the active component are coplanar. Such arrangements provide direct propagation of light between the waveguide and the active component as compared to arrangement where light is coupled from the waveguide to an active component not provided in line with the waveguide. However, physical alignment of the waveguide (and adjacent conducting layers) and the active component can result in electrical cross-talk. Such arrangement in particular would benefit from the flow of electricity being inhibited between the waveguide and the active component.

The following description relates to a semiconductor structure in which the flow of electricity between the waveguide (and, in examples, conducting layer in contact with the waveguide) and the active component is inhibited.

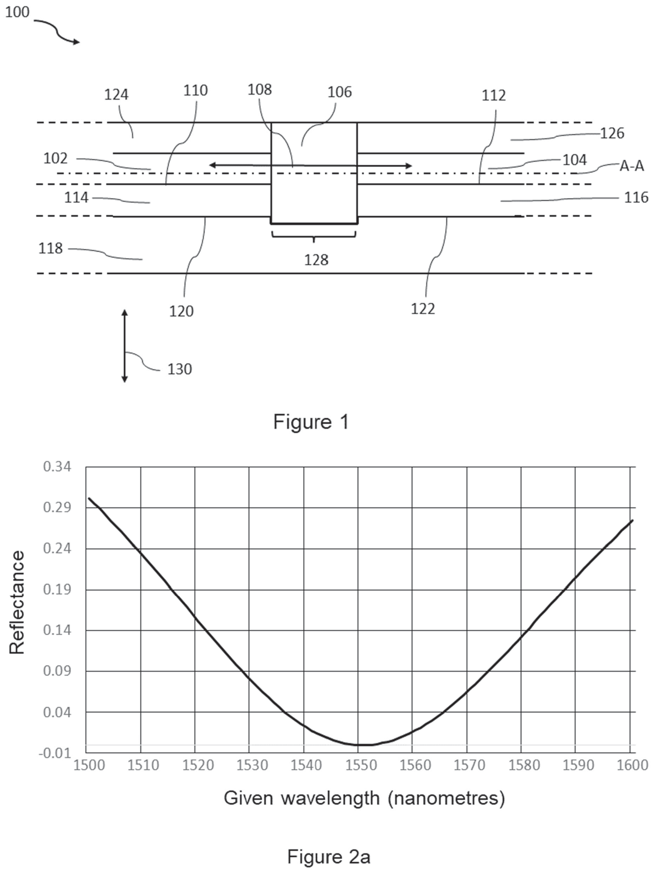

Figure 1 illustrates schematically a side cross-section of a first semiconductor structure 100 for a PIC according to examples. In these examples, the first semiconductor structure 100 comprises a waveguide 102. The first semiconductor structure 100 also comprises an active component 104 of the PIC. The active component 104, in contrast with a so-called passive component, is for example a component of the PIC to which a voltage may be applied and/or a current flow may be provided, either continuously or otherwise, in order for the active component 104 to perform its function. For example, the active component 104 is provided with electrical connections for the application of a voltage to perform its function. In other examples, an active component has electrodes for the active component to output an electrical signal converted from an optical signal. In some examples, the active component 104 is a photodetector. In other examples, the active component 104 is an amplifier or another active component. In the following description, the active component 104 is taken to be a photodiode 104 with an electrode or contact on e.g. a p-doped layer (126) for outputting a signal. For example, the photodiode 104 may be reverse biased to perform the function of converting an optical signal received from the waveguide 102 into an electrical signal.

The first semiconductor structure 100 comprises an electrically resistive material 106 between the waveguide 102 and the photodiode 104. The electrically resistive material 106 is along a light propagation axis 108 between the waveguide 102 and the photodiode 104. In the examples of Figure 1, the electrically resistive material 106 is in contact with the photodiode 104. In other examples, there is present another waveguide between the electrically resistive material 106 and the photodiode 104. For example, a section (e.g., a relatively short section) of layers corresponding to the layers on the left hand side of the electrically resistive material 106 (in the orientation of Figure 1) is present between the electrically resistive material 106 and the photodiode 104. The electrically resistive material has an electrical resistivity higher than the waveguide 102.

In the examples of Figure 1, the electrically resistive material 106 is also in contact with the waveguide 102. In some other examples, there may be other material or another structure (for providing a desired optical function) between the waveguide 102 and the electrically resistive material. In such examples, light is coupled into the electrically resistive material 106 via said other material.

The waveguide 102 is for guiding light. In use, light propagates within the waveguide 102 and is confined within the waveguide 102, due to reflection at the boundaries of the waveguide 102. The waveguide 102 has a refractive index higher than the refractive index of material in contact with the waveguide 102 at the boundaries at which confinement of light is desired. For example, due to this refractive index difference at the boundaries at which confinement of light is desired, total internal reflection takes place when the angle of incidence at these boundaries of the waveguide 102 is greater than the critical angle. In this manner, the waveguide 102 guides the propagation of the light. For a particular optical mode to propagate in the waveguide 102, it is desired that the light reflected at the boundaries of the waveguide 102 fulfils the conditions for constructive interference, as will be appreciated by the skilled person.

For example, particular optical modes of light are desired to propagate through the waveguide 102 depending on the desired application of the region of the PIC in question. The direction in which the optical modes propagate within the waveguide 102 is herein referred to as the light propagation direction. The light propagation axis 108 indicated in Figure 1 is defined by the light propagation direction.

The light propagation direction is the general direction in which the energy of the optical mode travels through the waveguide 102 and is not necessarily, for example, the direction defined by the angle of incidence at a boundary of the waveguide 102. In some applications, light propagates from left to right in the orientation of Figure 1, while in other applications, light propagates from right to left in the orientation of Figure 1.

In the examples of Figure 1, the waveguide 102 comprises a material which has a higher refractive index than the material in contact with the waveguide 102 above and below the waveguide 102 in the orientation shown in Figure 1. For example, the waveguide 102 comprises Indium Gallium Arsenide Phosphide (InGaAsP). More generally, in some examples, the waveguide 102 comprises (Al)InGaAs(P). The elements indicated in the parentheses can be interchangeable and the composition of the different elements is selected depending on the desired function. For example, the composition of Ga and As in InGaAs can be selected according to the desired bandgap. In some examples, the waveguide 108 is a layer of (Al)InGaAs(P). In other examples, the waveguide 108 comprises a plurality of sub-layers. In some such examples, the waveguide 108 comprises a (Al)InGaAs(P)/(Al)InGaAs(P) multiple quantum well structure. In some examples, the sub-layers are between 5 and 30 nanometres thick. The sub-layer stack of the waveguide 108 has a band gap selected in accordance with the desired application of the light polarisation converter 100.

The bandgap and therefore, as will be appreciated by those skilled in the art, the refractive index of the InGaAsP, for example, can be tuned. In some examples, the bandgap of the InGaAsP of the waveguide 108 is tuned to a wavelength of 1250 nanometres (e.g. for propagation of light of wavelength 1550 nanometres) or 1100 nanometres (e.g. for propagation of light of wavelength 1310 nanometres). In other examples, the wavelength to which the bandgap is tuned is different.

In the examples of Figure 1, the waveguide 102 and the photodiode 104 are in line with one another (with respect to the vertical direction in the orientation shown in Figure 1). In some examples, the waveguide 102 comprises a first surface 110, and the photodiode 104 comprises a second surface 112, wherein the first surface 110 and the second surface 112 are coplanar. Accordingly, deviation of the direction in which light propagates within the waveguide 102 is not required for propagation of the light into the photodiode 104. In other examples, the waveguide 102 and the photodiode 104 are vertically offset from one another, but still overlap in the vertical direction (in the orientation shown in Figure 1) such that deviation of the direction in which light propagates within the waveguide 102 is not required for propagation of the light into the photodiode 104.

In some examples, the electrical resistivity of the electrically resistive material 106 is at least four, e.g. eight, orders of magnitude higher than the electrical resistivity of the waveguide 102. For example, if the value of the resistivity of the waveguide on average is 1 Ohm*micrometre, then in such examples, the electrical resistivity of the electrically resistive material is 20 Ohm*metres or greater. For example, the electrically resistive material 106 has a high enough resistivity such that it does not conduct electricity at the voltage levels to be expected between the waveguide 102 and the photodiode 104. As such, the electrically resistive material 106 present between the waveguide 102 and the photodiode 104 inhibits the flow of electricity between the waveguide 102 and the photodiode 104. In some examples, the electrically resistive material comprises a dielectric material, e.g. Silicon Nitride (SiN) or Silicon Dioxide (SiO₂).

In use, light propagates between the waveguide 102 and the photodiode 104 via the electrically resistive material. In some examples, the electrically resistive material 106 has a refractive index lower than the refractive index of the photodiode 104. A lower refractive index than the photodiode 104 can avoid unwanted reflection of light at the interface between the electrically resistive material 106 and the photodiode 104, and result in efficient injection of light into the photodiode 104, for example.

As described above, if there are other conductive layers, the flow of electricity can also be inhibited between the photodiode 104 and such other conductive layers.

In the examples of Figure 1, the first semiconductor structure 100 comprises a first layer 114 in contact with the waveguide 102 and between the waveguide 102 and a substrate 118. In the examples of Figure 1, the first semiconductor structure 100 also comprises a second layer 116 in contact with the photodiode 104 and between the photodiode 104 and the substrate 118. In the examples of Figure 1, the electrically resistive material is between the first layer 114 and the second layer 116.

The first and second layers 114, 116 are doped semiconductor layers, for example. In some examples, the first and second layers 114, 116 are n-doped semiconductor layers. Therefore, the first and second layers 114, 116 are capable of conducting electricity. The electrically resistive material 106 between the first and second layers 114, 116 inhibits the flow of electricity between the photodiode 104 and the first layer 114, thereby inhibiting electrical cross-talk. For example, the resistivity of the electrically resistive material 106 is for inhibiting the flow of electricity between the photodiode 104 and the waveguide 102, and between the photodiode 104 and the first layer 114.

The substrate layer 118 comprises a material which does not conduct electricity at potential differences relevant for the first semiconductor structure 100. For example, the substrate layer 118 comprises semi-insulating material. The semi-insulating material has a high enough band-gap such that it acts as an insulator for the conditions within the first semiconductor structure 100. The components of the PIC are built on the substrate layer 118, for example. For example, the substrate layer 118 is common for the PIC as a whole. In the examples of Figure 1, the substrate layer 118 supports the waveguide 102 and the photodiode 104 but is not in contact with the waveguide 102 and the photodiode 104.

Those skilled in the art will appreciate that flow of electricity can be inhibited by breaking physical contact between conducting parts of a structure. In the examples of Figure 1, the substrate layer 118 comprises a first substrate surface 120 in contact with the first layer 114, and a second substrate surface 122 in contact with the second layer 116. The electrically resistive material 106 is between the first substrate surface 120 and the second substrate surface 122. This means that the electrically resistive material 106 extends past the first and second layers 114, 116 in the direction of the substrate layer 118. This ensures that the first layer 114 is not in contact with the second layer 116.

In the examples of Figure 1, the first semiconductor structure 100 comprises a first cladding layer 124 in contact with the waveguide 102. The first semiconductor structure 100 also comprises a second cladding layer 126 in contact with the photodiode 104. The electrically resistive material is between the first cladding layer 124 and the second cladding layer 126. The first and second cladding layers 124, 126 are doped semiconductor layers, for example. In some examples, the first and second cladding layers 124, 126 are p-doped semiconductor layers. Therefore, the first and second cladding layers 124, 126 are capable of conducting electricity. The electrically resistive material 106 between the first and second cladding layers 124, 126 inhibits the flow of electricity between the photodiode 104 and the first cladding layer 124, thereby inhibiting electrical cross-talk. For example, the resistivity of the electrically resistive material 106 is also for inhibiting the flow of electricity between the photodiode 104 and the first cladding layer 124.

The waveguide 102 is for propagation of a given wavelength of light (for example, 1550 nanometres) therein along the light propagation axis 108. A length 128 of the electrically resistive material 106 along the light propagation axis 108 is equal to an odd integer multiplied by a quarter of the given wavelength of light. Those skilled in the art will appreciate that this condition on the length 128 of the electrically resistive material 106 inhibits reflections. For example, light entering the electrically resistive material 106 from the waveguide 102 and light exiting the electrically resistive material 106 into the waveguide 102 (after having been reflected at the electrically resistive material 106 and photodiode 104 interface) would have a phase difference of π with the described length condition. This means that reflected light destructively interferes with the light entering the electrically resistive material 106 from the waveguide 102 and reflections are inhibited.

Figure 2a is a graph showing reflectance of the electrically resistive material 106 in the first semiconductor structure 100, for an example where the described length 128 of the electrically resistive material is 4296 nanometres. In Figure 2a, the vertical axis represents reflectance of the electrically resistive material 106 as part of the first semiconductor structure 100, and the horizontal axis represents wavelength of light in units of nanometres. In this example, the given wavelength of light is 1550 nanometres. It will be appreciated that 4296 nanometres is about 11.1 multiplied by a quarter of the given wavelength 1550 nanometres. In this case, the length 128 of the electrically resistive material substantially (within acceptable tolerances) meets the described condition to inhibit reflection. It can be seen from Figure 2a that the reflectance of the electrically resistive material 106 in the first semiconductor structure 100 is very low at a wavelength of 1550 nanometres.

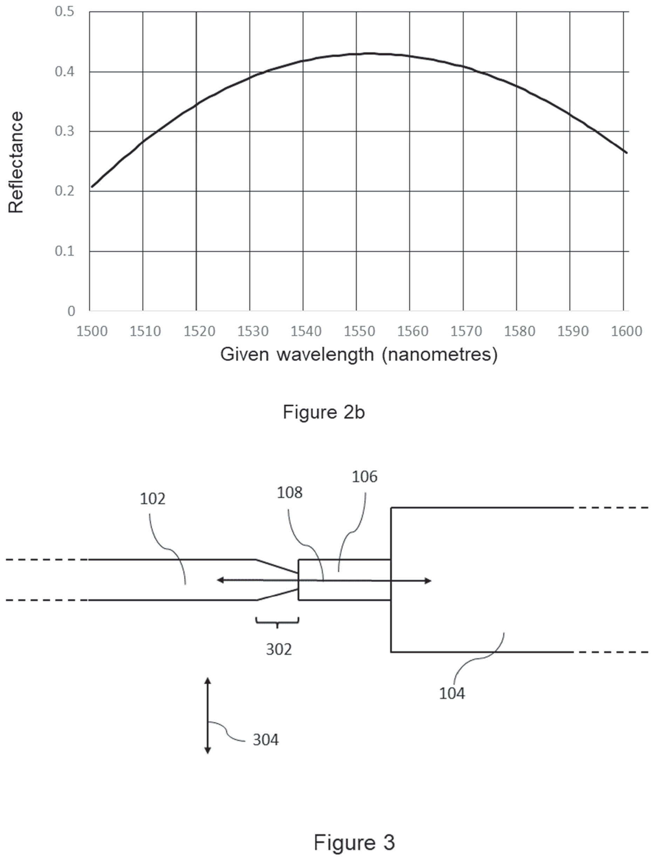

Figure 2b is a graph showing reflectance of the electrically resistive material 106 in the first semiconductor structure 100, for an example where the described length 128 of the electrically resistive material is 4570 nanometres. In Figure 2b, the vertical axis represents reflectance of the electrically resistive material 106 as part of the first semiconductor structure 100, and the horizontal axis represents wavelength of light in units of nanometres. In this example, the given wavelength of light is 1550 nanometres. It will be appreciated that 4570 nanometres is about 11.8 multiplied by a quarter of the given wavelength 1550 nanometres. In this case, the length 128 of the electrically resistive material does not meet the described condition to inhibit reflection because 11.8 is close to an even integer (i.e., 12). It can be seen from Figure 2b that the reflectance of the electrically resistive material 106 in the first semiconductor structure 100 is high at a wavelength of 1550 nanometres. Accordingly, the length 128 being 4296 nanometres provides inhibition of unwanted reflection as compared to the length 128 being 4570 nanometres.

By appropriately selecting the length 128 of the electrically resistive material along the light propagation axis 108, the electrically resistive material can also function as an anti-reflection layer. This provides for efficient injection of light into the photodiode 104, for example.

Although the described length 128 of the electrically resistive material 106 can be any odd integer multiple of a quarter of the given wavelength, shorter lengths are desired in some examples. For example, the longer the electrically resistive material 106 along the light propagation axis 108, the more difficult it can be to control the length 128 to be an odd integer multiple of a quarter of the given wavelength. For example, shorter lengths can give better control over the length of the electrically resistive material 106 along the light propagation axis 108.

Furthermore, in the examples of Figure 1, the electrically resistive material 106 is between the photodiode 104 and the waveguide 102, between the first and second layers 114, 116, and between the first cladding layer 124 and the second cladding layer 126. Therefore, the thickness of the electrically resistive material 106 in a first direction 130 perpendicular to the first substrate surface 120 is greater than the thickness of the waveguide 102 in the first direction.

In some such examples, light diffracted at the waveguide 102 and electrically resistive material 106 interface can have a propagation component in the first direction 130. Due to the greater thickness (in the vertical direction with respect to the orientation of Figure 1, perpendicular to the light propagation axis 108) of the electrically resistive material 106, the light therein is less confined in the first direction 130. Due to such a propagation component, the greater the length 128 of the electrically resistive material along the light propagation axis 108, the less light will reach the photodiode 104. Accordingly, the shorter the described length 128 of the electrically resistive material 106, the greater the amount of light that can be coupled between the waveguide 102 and the photodiode 104.

On the other hand, the greater the length 128 (and possibly other physical dimensions of the electrically resistive material 106), the greater the electrical resistance of the electrically resistive material 106. In examples, the dimensions of the electrically resistive material are chosen taking into account these factors. In one example, the length 128 is 4570 nanometres as in the case of Figure 2a.

A width (e.g. in second direction 304 (perpendicular the length 128 and thickness (in first direction 130)) of the electrically resistive material is for example greater than or equal to a width of a portion of the waveguide which contacts the electrically resistive material. In some examples, the electrically resistive material is a cuboidal block in shape, whereas in other examples the electrically resistive material is shaped to surround the active component such as the photodiode when viewed in plan view. In the latter examples, the active component is therefore not just more electrically isolated on the waveguide side, but is more electrically isolated from all sides in plan view; this could be fabricated by etching a space as a trench (with similar thickness and length as described herein for feature 106) around the active component, then providing / depositing one or more electrically resistive materials in that space (e.g. there could be a gas such as air between the waveguide and the active component, and deposited electrically resistive material in the remaining space surrounding the active component.

In some examples a width of a portion of the waveguide in contact with the electrically resistive material is greater than a width of a portion of the waveguide not in contact with the electrically resistive material. This wider portion of waveguide at the interface with the electrically resistive material can help mitigate rounding of edges by a lithographic and/or etching process which might otherwise compromise light transmission from the waveguide into the electrically resistive material. With the wider portion of waveguide, any such rounding during fabrication is of waveguide material at edges of the wider portion away from the portion of waveguide where light is transmitted into the electrically resistive portion.

Figure 3 illustrates schematically a plan cross-section view of the first semiconductor structure 100 according to examples. Figure 3 shows a cross section along the line A-A indicated in Figure 1. In the examples of Figure 3, the waveguide 102 comprises a tapered portion 302 in contact with the electrically resistive material 106. The tapered portion 302 is tapered for reducing a refractive index mismatch for light propagating from the waveguide 102 into the electrically resistive material 106.

In the examples of Figure 3, the width of the tapered portion 302 in a second direction 304 is progressively greater at positions further away from the electrically resistive material 106. The second direction 304 is perpendicular to the light propagation axis 108 and parallel to the first substrate surface 120.

For example, the tapered portion 302 reduces the refractive index mismatch for light propagating from the waveguide 102 to the electrically resistive material 106 because the taper affects an effective refractive index of the light in the tapered portion 302. As used herein, the effective refractive index is the refractive index which the light propagating within a material experiences. The effective refractive index is not necessarily the refractive index of the material within which the light is propagating in isolation, for example. For example, when light propagated within the waveguide 102, other material in the vicinity of the waveguide 102 can also influence the refractive index experienced by light propagating within the waveguide 102 because part of the optical mode overlaps the other material in the vicinity of the waveguide 102. For example, the effective refractive index depends on the waveguide structure 100 as a whole. The skilled person will appreciate that the effective refractive index depends on parameters including the wavelength of light and also depending on the particular optical mode in question.

The width of the tapered portion 302 in the second direction 304 is progressively smaller at positions closer to the electrically resistive material 106. Accordingly, as light propagates within the tapered portion 302 towards the electrically resistive material 106, the optical mode of the light has progressively greater overlap with other material in the vicinity of the tapered portion 302. This causes the effective refractive index experienced by the optical mode of the light to change as the light propagates towards the electrically resistive material 106.

In some examples, the refractive index of the waveguide 102 is higher than the refractive index of the electrically resistive material 106. The refractive index of the waveguide 102 is also higher than material otherwise surrounding the waveguide 102. Therefore, the effective index experienced by the light propagating towards the electrically resistive material 106 in the tapered portion 302 progressively reduces, and the refractive index mismatch for light propagating from the waveguide 102 into the electrically resistive material 106 is reduced.

The first semiconductor structure 100 can comprise further layers (not shown), for example, on top of the part of the structure shown in Figure 1.

Providing the electrically resistive material 106 in the described arrangement electrically isolates the photodiode 104 from all the conductive layers on the waveguide 102 side of the electrically resistive material 106. For example, the arrangement is such that even in the direction into/out of the page in Figure 1, the layers on the waveguide 102 side of the electrically resistive material 106 do not contact the photodiode 104.

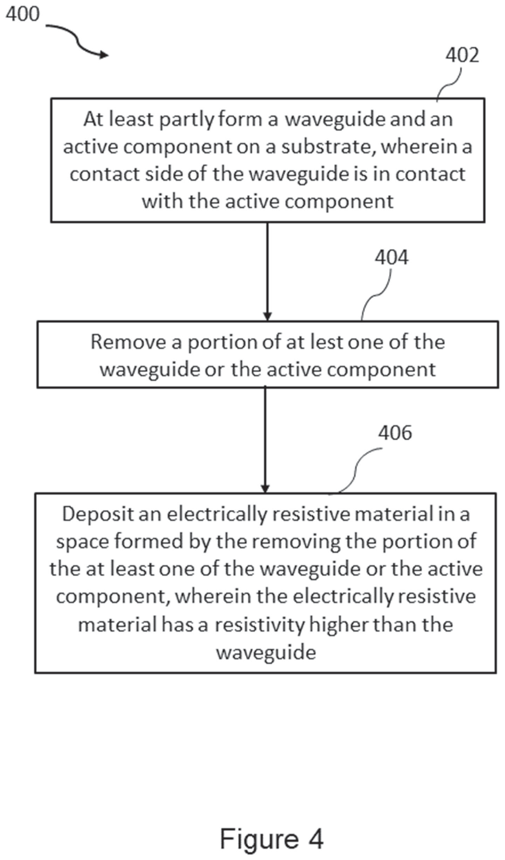

Figure 4 is a flow diagram illustrating a method 400 of manufacturing a semiconductor structure for a PIC. For example, the method 400 is for manufacturing the first semiconductor structure 100 described above or any other example described herein.

At block 402 of the method 400, a waveguide and an active component are at least partly formed on a substrate. For example, the described waveguide 102 and the described photodiode 104 are at least partly formed on the substrate layer 118 as part of block 402. As referred to herein, formed on the substrate means supported by the substrate and does not preclude there being other layers between the substrate and the waveguide and/or the active component. In some examples, the waveguide 102 and the photodiode 104 are in contact with the substrate layer 118. In other examples, there are one or more other layers between the waveguide 102 and the substrate layer 118, and the active component and the substrate layer 118.

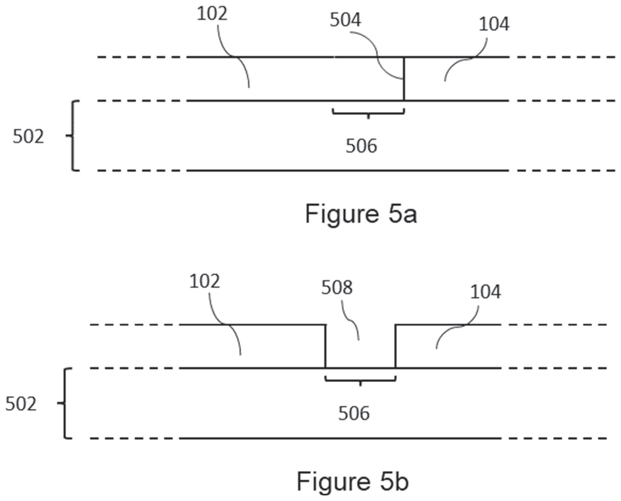

Figures 5a to 5h illustrates schematically side cross-sections of a first semiconductor structure 100 at various stages of manufacture during the method 400 being performed and at various levels of detail. For example, not all layers that may be present are shown in each of Figures 5a to 5h. Figure 5a illustrates the first semiconductor structure 100 after block 402 is performed. There are one or more lower layers 502. For example, the lower layers 502 represent the substrate layer 118 and the above described first and second layers 114, 116. A contact side 504 of the waveguide 102 is in contact with the photodiode 104.

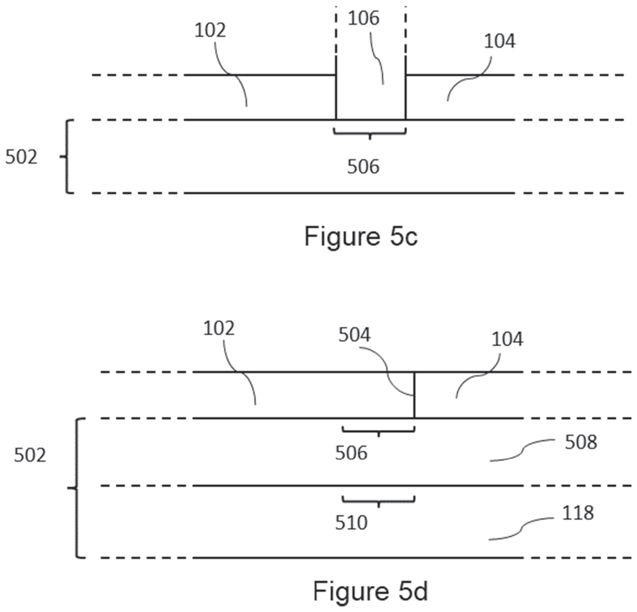

At block 404 of the method 400, a portion 506 of the waveguide 102 including the contact side 504 is removed. The result of performing block 504 is shown in Figure 5b. The removal of the portion 506 of the waveguide 102 forms a space 508. At block 406, the described electrically resistive material 106 is deposited in the space 508 formed by the removal of the portion 506 of the waveguide 102. The electrically resistive material 106 has a resistivity higher than the waveguide 102. The result of performing block 406 is shown in Figure 5c.

In some examples, the method 400 includes further actions. For example, the method 400 further comprises at least partly forming an intermediate layer 508 on the substrate layer 118. In such examples, the method 400 also comprises at least partly forming the waveguide 102 and the photodiode 104 on the intermediate layer 508. For example, material for the intermediate layer 508 is deposited on the substrate layer 118. Then, material for the waveguide 102 and the photodiode 104 is deposited on the top surface of the intermediate layer 508 resulting in the arrangement shown in Figure 5d.

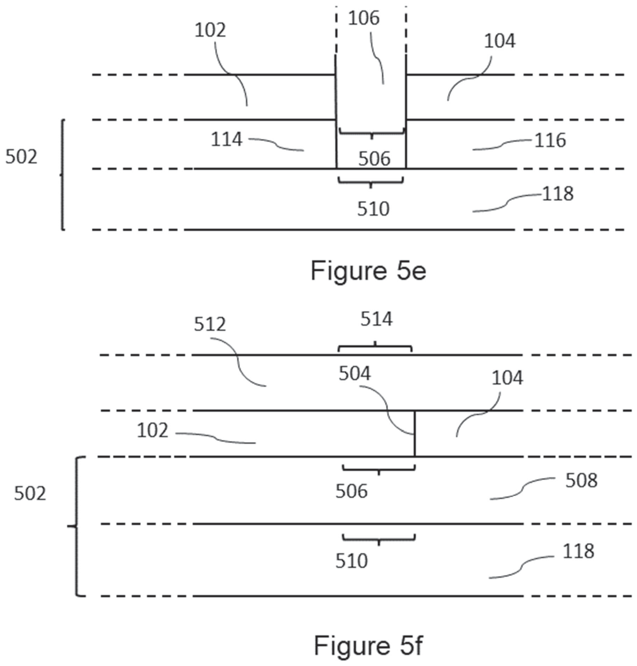

For example, a first portion 510 of the intermediate layer 508 in contact with the described portion of the waveguide 102 including the contact side 504 is removed. The first portion 510 is removed together with the described portion 506 of the waveguide 102 including the contact side 504. The electrically resistive material 106 is deposited in the space formed by the removal of the first portion 510 of the intermediate layer 508 and the portion 506 of the waveguide 102 including the contact side 504. Performing such actions results in the formation of the above described first layer 114 and second layer 116. Performing these actions results in the arrangement shown in Figure 5e

In some examples, the method 400 also comprises removing a portion of the substrate layer 118 overlaid by the portion 506 of the waveguide 102 including the contact side 504, and depositing the electrically resistive material 106 in a space formed by the removal of the portion of the substrate layer 118. Performing such actions results in the formation of the first substrate surface 120 and the second substrate surface 122, where there is the electrically resistive material 106 between the first and second substrate surfaces, as shown in Figure 1.

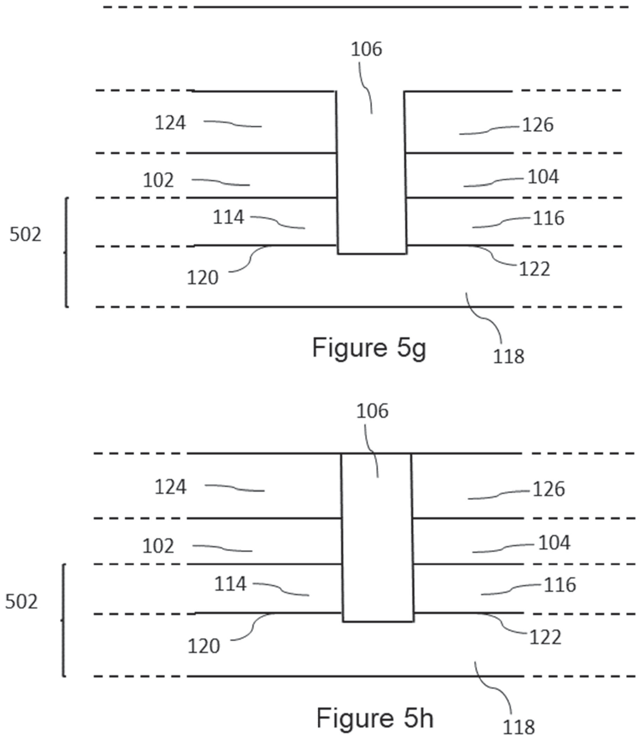

In some examples, the method 400 comprises at least partly forming a cladding layer 512 on the waveguide and the active component. The cladding layer 512 is at least partly formed before the above described removal of material and deposition of the electrically resistive material in the space formed by said removal of material. In some examples, other layers are at least partly formed on top of the cladding layer 512 prior to removal of material. Figure 5f shows example results of at least partly forming the cladding layer 512. For example, a portion 514 of the cladding layer 512 in contact with the portion 506 of the waveguide 102 including the contact side 504 is removed, and the electrically resistive material is deposited in a space formed by the removal of the portion 514 of the cladding layer 512. Examples of the result of these actions being performed is shown in Figure 5g. In the examples of Figure 5g, a portion of the substrate layer 118 has also been removed, as described above, to be filled with the electrically resistive material 106. Performing the actions leading to the arrangement of Figure 5g also results in the formation of the first cladding layer 124 and the second cladding layer 126.

As described above, material is removed in order to create space into which the electrically resistive material 106 is to be deposited. As described above, in some examples, the length 128 of the electrically resistive material 106 along the light propagation axis 108 is equal to an odd integer multiplied by a quarter of the given wavelength of light in order to inhibit reflection. In these examples, removal techniques are used that are precise enough to control the length of the space created by the removal precisely enough to provide lengths equal to an odd integer multiplied by a quarter of the given wavelength of light. For example, lithography techniques and/or apparatus (known to the person skilled in the art) which provide such precision are used.

In some examples, as part of the method 400, material from the waveguide 102 is removed to form the described tapered portion for reducing a refractive index mismatch for light propagating from the waveguide 102 into the electrically resistive material 106. For example, material is removed from the waveguide 102 to form the described tapered portion before material for the cladding layer is deposited on the waveguide 102.

As described above, material from various layers is removed to create a space to be filled by the electrically resistive material 106. Whilst this is described above in relation to removing a portion of the waveguide, in other examples a portion of the active component and/or a portion of the waveguide is removed. In some examples, depositing the electrically resistive material 106 depositing material to cover the current top layers of the semiconductor structure. For example, the electrically resistive material 106 is deposited to fill the space created by the described removal of material and to cover the first cladding layer 124 and the second cladding layer 126. The result of such deposition is shown in Figure 5g. For example, unwanted electrically resistive material 106 is subsequently removed. For example, the electrically resistive material 106 is removed the expose the top surfaces of the first and second cladding layers 124, 126, but is not removed from the space created by the above described removal of material from the cladding layer, waveguide and intermediate layer. Figure 5h shows examples of the results of such removal.

For example, subsequently to arriving at the structure shown in Figure 5h, other layers (for example, the third cladding layer 132) are deposited on top of the structure of Figure 5h.

In some examples, the method 400 comprises removing material overlaid on a second portion of the intermediate layer to expose intermediate layer material, and forming an electrical connection with the exposed intermediate layer material. Electrical contact is also made with the cladding in contact with the waveguide 102 and the photodiode 104

In the above description, reference is made to removal of material. Those skilled in the art will appreciate the techniques for removal material. For example, wet etching techniques or dry etching techniques are be used, depending on the desired results. For example, a mask is used where material not covered by the mask is removed upon an etching technique being deployed.

In the above description, reference is made to at least partly forming layers and the like. In some examples, a layer referred to in this manner is simply formed by depositing the relevant material, without requiring further steps. In other examples, further steps are performed to complete the formation of a layer (for example, a curing step, an etching step to define the extent of a layer, etc.). In some examples, the further steps to complete the formation of a layer are performed before further material is deposited on top of the layer in question. In other examples, the further steps to complete the formation of a layer are performed after further material is deposited on top of the layer in question.

As the skilled person will appreciate, various techniques can be used to deposit the material in accordance with described examples. Such techniques include, for example, chemical vapour deposition techniques such as vapour phase epitaxy (VPE) metalorganic vapour-phase epitaxy (MOVPE) or molecular beam epitaxy (MBE). The skilled person will appreciate that etching techniques (for example, using patterned masks) are used to remove material in accordance with described examples. The above examples are to be understood as illustrative examples.

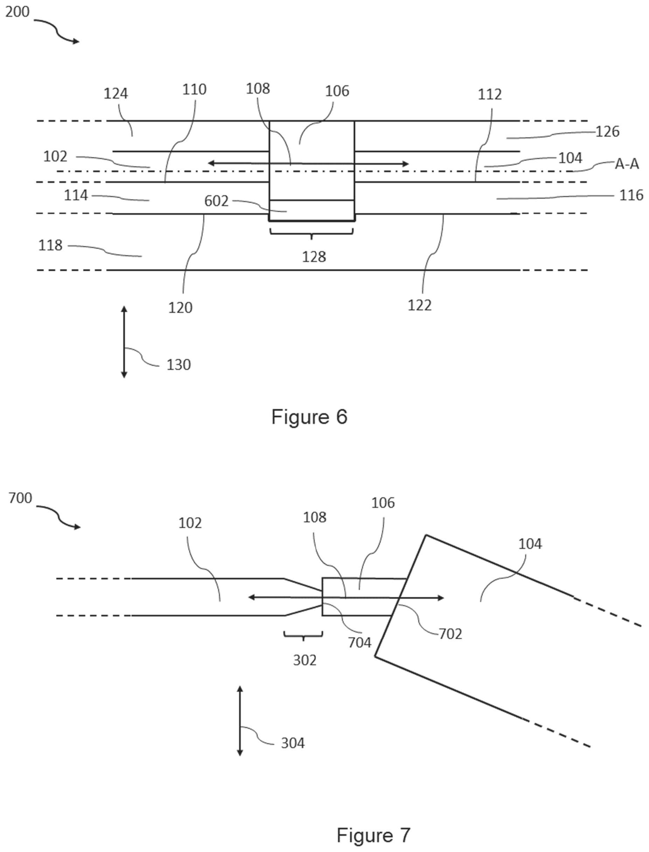

Figure 6 illustrates schematically a side cross-section of a second semiconductor structure 600 for a PIC according to examples. The second semiconductor structure 200 is similar to the previously described first semiconductor structure 100, except that the second semiconductor structure comprises a light leakage reducing material 602. In these examples, part of the space between the first and second layers 114, 116 is occupied by the light leakage reducing material 602, and part of the space between the first and second layers 114, 116 is occupied by the electrically resistive material 106. In examples, the light leakage reducing material 602 is also electrically resistive so as to inhibit the flow of electricity. However, the light leakage reducing material 602 is included to reduce leakage of light into the substrate layer 118. For example, the light leakage reducing material 602 is SiO₂. For example, in the method 400, the space created by the removal of a portion of the substrate layer, a first portion of the intermediate layer, a portion of the waveguide and a portion of the cladding layer, as described above with reference to Figures 5a to 5h, is first partially filled with the light leakage reducing material 602 before deposition of the electrically resistive material 106.

Figure 7 illustrates schematically a plan cross-section view of a third semiconductor structure 700 according to examples. The third semiconductor structure 700 can include any of the features described above. The third semiconductor structure 700 is different in that a first side 702 of the electrically resistive material 106 in contact with the active component 104 is at a non-zero angle relative to a second side 704 of the electrically resistive material 106 in contact with the waveguide 102. Light entering the active component 104 can be reflected at the first side 702. However, the described angle of the first side 702 means that reflected light does not follow the light propagation axis 108 for the light propagating from the waveguide 102. Therefore, due to the angle, less of the light reflected at the first side 702 would enter the waveguide 102. Accordingly, the arrangement of the third semiconductor structure 700 inhibits unwanted reflections from coupling into the waveguide 102.

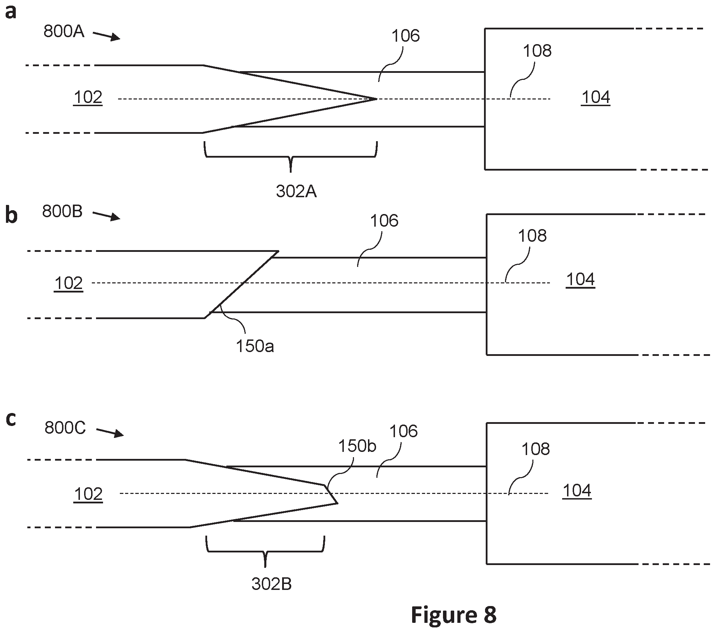

In the following Figures 8a-c, 9a-c, 10a-c, and 11, further examples of semiconductor structures are illustrated and described. The example semiconductor structures described hereafter can include any of the features described previously; that is, the examples hereafter comprise the waveguide 102, the active component 104 of the photonic integrated circuit, and the electrically resistive material 106 arranged along the light propagation axis 108. Differences between the examples presented hereafter and the previously presented examples will be explicitly described.

Figures 8a-c illustrate schematically plan views of a fourth semiconductor structure 800A, a fifth semiconductor structure 800B, and a sixth semiconductor structure 800C, respectively, according to examples.

The fourth semiconductor structure 800A is illustrated in Figure 8a. The fourth semiconductor structure 800A is different from previously presented examples in that it comprises a tapered portion 302A. The tapered portion 302A, similar to the tapered portion 302 of semiconductor structure 100 shown in Figure 3, has a width in a direction perpendicular to the light propagation axis 108 which is progressively greater at positions further away from the electrically resistive material 106. In the semiconductor structure 800A, the tapered portion 302A tapers down to a width of less than 400 nanometres. In general, the tapered portion 302A can be considered to taper down to a point at a position closest to the electrically resistive material or to the active component. The tapered portion 302A can be considered to taper down to a point insofar as a point is achievable within manufacturing tolerances.

The tapered portion 302A of the waveguide 102, in tapering down to a width which is small relative to a wavelength of light, approaches a cut-off condition for light guidance at that wavelength and within a specific mode. A cut-off condition refers to, for example, a geometry of the waveguide for which light is no longer considered to be guided. That is, light having a first wavelength, being guided in a mode of the waveguide 102, propagates into the tapered portion 302A. The tapered portion 302A tapers down to a width, such as the above example width of 400 nanometres, whereupon the mode at the first wavelength becomes cut-off. This means the light at the first wavelength is no longer guided by the tapered portion 302A of the waveguide 102 in this mode. Instead of being guided, the light couples out of the tapered portion 302A, in this example into the electrically resistive material 106. Reflection of the light back along the waveguide 102 can be reduced in tapering the tapered portion 302A to satisfy a cut-off condition. In general, the width of the tapered portion 302A which satisfies the cut-off condition is dependent upon the wavelength of light being guided in the waveguide 102 and the tapered portion 302A. In this example, the taper profile, that is, how the width of the tapered portion 302A perpendicular to the light propagation axis 108 varies with length parallel to the light propagation axis, is an adiabatic taper. As the skilled person will appreciate, an adiabatic taper means the width varies slowly such that the evolution of a mode within the taper can be considered lossless. This can improve the coupling of light into the electrically resistive material 106 such that more light from the waveguide 102 is received at the active component 106, and reduce reflection of light back along the waveguide 102.

Additionally, the tapered portion 302A can reduce the wavelength sensitivity of the reflectance of the electrically resistive material 106 illustrated in Figure 2a. That is, a low reflectance of the electrically resistive material 106 can be achieved across a broader range of wavelengths. As the skilled person will appreciate, the resonance condition which produces reflection can arise from periodically spaced interfaces of the electrically resistive material 106 with materials having a different refractive index. In this example, the resonance condition arises from the distance between the interface of the electrically resistive material 106 with the waveguide 102, and the interface of the electrically resistive material 106 with the active component 104. The geometry of the tapered portion 302A can be thought of as disrupting this resonance condition to thereby reduce reflection of light from the electrically resistive material 106 back down the waveguide 102 across a broader wavelength range. This can allow the semiconductor structure 800A to be used over a broader wavelength range, in turn rendering the semiconductor structure 800A more robust against fabrication errors.

The fifth semiconductor structure 800B is illustrated in Figure 8b. In the fifth semiconductor structure 800B, the waveguide 102 comprises a facet 150a which is at least partially in contact with the electrically resistive material 106, and in Figure 8b, is substantially entirely in contact with the electrically resistive material such that all portions of the facet 150a contact the electrically resistive material 106. A facet can be considered to be, for example, an end face or entry face of a waveguide, or more generally of a structure of the photonic integrated circuit, through which light can propagate. Light propagating through the waveguide 102 along the light propagation axis 108 propagates through the facet 150a into the electrically resistive material 106. The facet 150a intersects the light propagation axis 108 at a non-perpendicular angle. The facet 150a can therefore be considered to be angled relative to the light propagation axis 108. In this example, the facet 150a is 7 degrees away from being perpendicular to the light propagation axis 108 and so can be considered to have an angle of 7 degrees. The facet 150a being angled can inhibit unwanted reflections from propagation back down the waveguide 102.

The sixth semiconductor structure 800C is illustrated in Figure 8C. The sixth Semiconductor structure 800C comprises a tapered portion 302B and a facet 150b which is angled by, in this example, 7 degrees. The facet 150b is located at an end of the tapered portion 302 nearest the electrically resistive material 106, and light from the waveguide 102 propagates at least partially through the facet 150b into the electrically resistive material 106. The tapered portion 302B can reduce mode mismatch between the waveguide 102 and the electrically resistive material 106, but does not necessarily taper to a width associated with mode cut-off such as the tapered portion 302A of Figure 8a, and the facet 150b can inhibit unwanted reflections from propagation back down the waveguide 102.

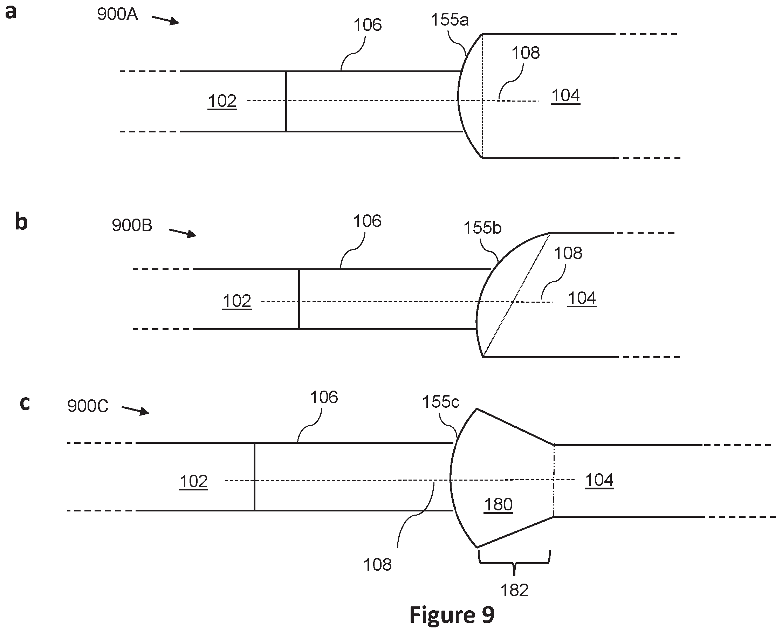

Figures 9a-c illustrate schematically plan views, according to examples, of a seventh semiconductor structure 900A, an eighth semiconductor structure 900B, and a ninth semiconductor structure 900C, respectively.

The seventh semiconductor structure 900A is illustrated in Figure 9a. The active component 104 comprises a facet 155a which is at least partially in contact with the electrically resistive material 106, and in Figure 9a, is entirely in contact with the electrically resistive material 106. Light propagating through the electrically resistive material 106 along the light propagation axis 108 enters the active component 104 through the facet 155a. The facet 155a is convex. That is, the facet 155a is curved, and curves outwards relative to the active component 155a. The facet 155a being curved, in this example being convex, can mean that light is reflected away from the light propagation axis 108, which can prevent light from being reflected back into the waveguide 102. The facet 155a, being convex, can function as a lens, and in receiving light which has spread out after leaving the waveguide 102 can collimate or focus the light into the active component 104. The facet 155a, in being convex, can thereby increase the amount of light received by the active component 104.

The eighth semiconductor structure 900B is illustrated in Figure 9b. The active component comprises a facet 155b which is at least partially in contact with the electrically resistive material 106, and in the Figure 9b, is in contact with the electrically resistive material 106 over a majority of the facet 155b. The facet 155b is convex, similar to the facet 155a of Figure 9a. The facet 155b is also tilted in that it does not intersect the light propagation axis 108 perpendicularly. This can further reduce reflection of light back into the waveguide 102.

The ninth semiconductor structure 900C is illustrated in Figure 9c. The ninth semiconductor structure 900C comprises a second waveguide 180. The second waveguide 180 is disposed between the electrically resistive material 106 and the active component 104. Light propagating along the light propagation axis through the electrically resistive material 106 couples into the second waveguide 180, whereupon the light propagates through the second waveguide 180 and into the active component 104. The second waveguide 180 may comprise a similar or identical material composition to the first waveguide 102, which is described earlier, or may comprise a different material composition.

The second waveguide 180 comprises a facet 155c which is at least partially in contact with the electrically resistive material 106, and in Figure 9c is in contact with the electrically resistive material 106 over a majority of the facet 155c. As for the previously described facets 155a,b, light propagating along the light propagation axis 108 through the electrically resistive material 106 propagates through the facet 155c.

The second waveguide 180 has a width, in a direction perpendicular to the light propagation axis 108, which is greater than the width of the first waveguide 102 in a direction perpendicular to the light propagation axis 108. The second waveguide 180 can collect light which has emerged from the first waveguide 102, even if the light has spread since leaving the first waveguide 102.

The second waveguide 180 comprises a second tapered portion 182. A width of the second tapered portion 182 in a direction perpendicular to the light propagation axis 182 is progressively greater at positions further away from the active component 104. The size of the active component 104, such as the width in the direction perpendicular to the light propagation axis 182, can play a role in determining the behaviour of the active component 104, such as determining an operation speed or rate. High-speed operation or capabilities may require the active component to be beneath a certain spatial size, such as having a sufficiently small width in a direction perpendicular to the light propagation axis 108. The second waveguide 180, comprising a second tapered portion 182, can thereby collect light at a wider end, towards the electrically resistive material, and taper down to a smaller size to interface with the active component 104. In this way, the active component 104 can remain small to retain, for example, high-speed capabilities, whilst the second waveguide 180 collects light from the first waveguide 102.

The second waveguide 180 comprises a facet 155c which is at least partially in contact with the electrically resistive material 106. In this example, the facet 155c of the second waveguide 180 is curved, in this example being convex, similar to the facets 155a, 155b described previously with reference to Figures 9a and 9b. The facet 155c of the second waveguide 180 being curved, in this example convex, can reduce reflection of light back into the waveguide 102. The facet 155c of the second waveguide 180 being convex can function as a lens, to thereby more effectively couple light into the second waveguide 180 by effectively collimating and/or focussing light.

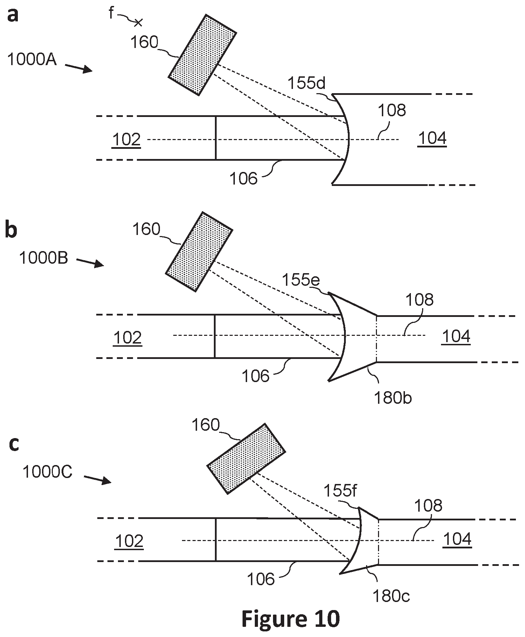

Figures 10a-c illustrate schematically plan views of a tenth semiconductor structure 1000A, eleventh semiconductor structure 1000B, and a twelfth semiconductor structure 1000C, respectively, according to examples.

The tenth semiconductor structure 1000A is illustrated in Figure 10a. In the tenth semiconductor structure 1000A, the active component 104 comprises a facet 155c. The facet 155c is curved, and in this example is concave. That is, the facet 155c curves inwards relative to the active component 104. The facet 155c being curved, in this example concave, means that light can be reflected away from the light propagation axis 108 and thereby reduce reflection of light back into the waveguide 102. Furthermore, the facet 155c being concave means reflected light can be reflected towards a common focal point, f. The common focal point f is illustrated in Figure 10a but omitted from figures 10b, 10c. This can prevent light from being reflected towards surrounding elements of the photonic integrated circuit, which may interfere with performance. This can in turn improve reliability and performance of the photonic integrated circuit.

The tenth semiconductor structure 1000A comprises an absorber element 160. The absorber element 160 is positioned, with respect to the light propagation axis 108, between the active component 104 and the waveguide 102, but spatially offset from the light propagation axis 108 and angled towards the active component 104. In other examples, the absorber element 160 may be positioned next to the waveguide 102. Generally, the absorber element 160 is positioned between the facet 155c and the common focal point f of the facet 155c, such that light reflected by the facet 155c is absorbed by the absorber element 160. The position of the absorber element 160 in any given example may, therefore, be dependent on the optical properties of the facet 155, such as the angles at which light will be reflected from the facet 155, and where a focal point, if any, of the facet 155 is located.

More generally, in other examples, the absorber element 160, or a plurality of absorbing elements, may be disposed around the waveguide 102, electrically resistive material 106 and active component 104 to absorb reflected light. In some examples, the absorber element 160 is formed from a stack of semiconductor layers suitable for use as a photodetector. In some such examples, the absorber element 160 may be used as a photodetector, and can receive focussed light reflected from the concave facet 155d,e,f which can improve performance of the photodetector. In some examples the active component 104 may not be used, or may be intermittently used, as a photodetector as the absorber element 160 is used instead, the absorbing element 160 being separated from the waveguide 102 by the electrically resistive material 106 in a similar manner to the active component 104. In some examples, the absorber element 160 and active component 104 may both be photodetectors and used concurrently as photodetectors for, for example, introducing redundancy in the photodetector measurements which may improve reliability in the PIC performance.

The eleventh semiconductor structure 1000B is illustrated in Figure 10b. The eleventh semiconductor structure 1000B comprises a second waveguide 180b which is similar in purpose to the second waveguide 180 of the ninth semiconductor structure 900C of Figure 9c. The second waveguide 180b comprises a facet 155e at least partially in contact with the electrically resistive material 106. The facet 155e is concave and is similar to the facet 155d of the active component 104 in the tenth semiconductor structure 1000A of Figure 10a. Again, similar to the ninth semiconductor structure, the second waveguide 180b has, in a direction perpendicular to the light propagation axis 108, a width greater than the active component 140. In this way, the active component 104 can be suitable for high-speed operation whilst the second waveguide 180b can collect light from the first waveguide 102.

The twelfth semiconductor structure 1000C is illustrated in Figure 10c. The twelfth semiconductor structure 1000C of Figure 10c is otherwise identical to the eleventh semiconductor structure 1000B of Figure 10b, but the second waveguide 180b comprises a facet 155f which is concave and which intersects the light propagation axis at a non-perpendicular angle. This can further reduce reflections back into the waveguide 102, and can reflect light further away from the light propagation axis 108. In other examples a second waveguide 180c may not be included, and instead the active component 104 may comprise a concave facet such as the facet 155f.

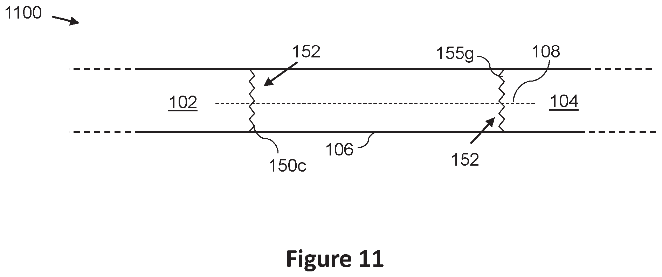

Figure 11 illustrates a thirteenth semiconductor structure 1100 according to examples. In the thirteenth semiconductor structure 1100, the waveguide 102 comprises a first facet 150c at least partially in contact with the electrically resistive material 106 and the active component 104 comprises a second facet 155g at least partially in contact with the electrically resistive material 106, in Figure 11 the first facet 150c and second facet 155g being substantially entirely in contact with the electrically resistive material 106. Each facet 150c, 155g comprises a respective periodic structure 152 configured as an anti-reflective grating. A surface comprising the periodic structure 152, for example with sub-wavelength distances between constituent structures of the periodic structure 152, can reduce reflections relative to, for example, a flat surface made of the same material as the periodic structure 152. In other words, in some examples, the periodic structure 152 has a sub-wavelength-scale pitch. The constituent structures of the periodic structure 152 are in, this example, teeth-shaped structures, but in other examples the constituent structures may have other geometries such as grooves. In the examples of the thirteenth semiconductor structure 1100, the semiconductor structure 1100 is intended for use with light having a wavelength of 1550 nm, and the periodic structure 152 has a pitch of 500 nm. The skilled person will appreciate the pitch of the periodic structure 152 can be smaller, for example when a shorter wavelength is used, or longer, for example when a longer wavelength is used.

The waveguide 102, comprising the first facet 150c configured as an anti-reflective grating, can thereby reduce reflection of light from the interface of the waveguide 102 with the electrically resistive material 106. Similarly, the active component 104, comprising the second facet 155f configured as an anti-reflective grating, can thereby reduce reflection of light from the interface of the electrically resistive material 106 with the active component 104. This can reduce reflection of light into the waveguide 102. In other examples, only one of the waveguide 102 or the active component 104 comprises a periodic structure configured as an anti-reflective grating.

It will be appreciated that features illustrated by the above examples can be combined, and features are not limited to appearing in the examples described above. In examples, any of the previously described waveguides may be used with any of the previously described active components. For example, the semiconductor structure can comprise a waveguide comprising a first facet, the first facet being convex or concave, and an active component comprising a second facet, the second facet being convex or concave. Additionally, the facets may be concave or convex and also comprise a periodic structure configured as an anti-reflective grating. In the above examples, facets which in some examples are associated with the active component 104 may instead be associated with a second waveguide between the active component 104 and the electrically insulative material 106. For example, the second waveguide may comprise a periodic structure configured as an anti-reflection grating.

In examples, the active component, or the second waveguide associated with the active component, could comprise a facet which is not curved but is angled with respect to the light propagation axis, similar to the facet 150a. In some examples where the first waveguide comprises a first facet of, for example, 7 degrees, the active component may comprise a second facet which is angled 1-2 degrees differently from the first facet, for example having an angle of 6 or 9 degrees. In other examples, the first facet and the second facet are angled by the same amount, for example both by 7 degrees. In general, the angle can be determined by the optical mode properties, such as an optical mode field size, and selected to select a lowest reflection for a particular mode.

In the above examples, facets described as being at least partially in contact with the electrically resistive material may, in some examples, be entirely in contact with the electrically resistive material such that all portions of the facet surface are in contact with electrically resistive material. In other examples, a majority of the facet surface are in contact with the electrically resistive material.

In examples, the electrically resistive material 106 is a vacuum or air or another gas, such that the waveguide 102 can be considered to be separated from the active component 104 by an air gap.

In the described Figures, dashed lines are included at the edges of certain parts to indicate continuation of the parts in question beyond what is schematically illustrated in the Figures. The Figures include schematic illustrations of structures related to the described examples of the semiconductor structures. None of the Figures should be taken to indicate precise proportions with respect to any other Figure.

It is to be understood that any feature described in relation to any one example may be used alone, or in combination with other features described, and may also be used in combination with one or more features of any other of the examples, or any combination of any other of the examples. Furthermore, equivalents and modifications not described above may also be employed without departing from the scope of the accompanying claims.

Further examples in accordance with the present disclosure are given in the following numbered clauses:
Clause 1. A semiconductor structure for a photonic integrated circuit, comprising:
   a waveguide;
   an active component of the photonic integrated circuit; and
   an electrically resistive material between the waveguide and the active component along a light propagation axis between the waveguide and the active component, wherein the electrically resistive material has an electrical resistivity higher than the waveguide.
Clause 2. The semiconductor structure according to clause 1, wherein:
   the electrical resistivity of the electrically resistive material is at least eight orders of magnitude higher than the electrical resistivity of the waveguide.
Clause 3. The semiconductor structure according to clause 2, wherein:
   the electrically resistive material comprises Silicon Nitride.
Clause 4. The semiconductor structure according to any preceding clause, wherein
   the waveguide comprises a first surface, and the active component comprises a second surface, wherein the first surface and the second surface are coplanar.
Clause 5. The semiconductor structure according to any preceding clause, comprising:
   a first layer in contact with the waveguide and between the waveguide and a substrate; and
   a second layer in contact with the active component and between the active component and the substrate,
   wherein:
   the electrically resistive material is between the first layer and the second layer.
Clause 6. The semiconductor structure according to clause 5, wherein:
   the substrate comprises a first substrate surface in contact with the first layer, and a second substrate surface in contact with the second layer; and
   the semiconductor structure comprises a light leakage reducing material between the first substrate surface and the second substrate surface.
Clause 7. The semiconductor structure according to clause 5, wherein:
   the substrate comprises a first substrate surface in contact with the first layer, and a second substrate surface in contact with the second layer; and
   the semiconductor structure comprises the electrically resistive material between the first substrate surface and the second substrate surface.
Clause 8. The semiconductor structure according to any preceding clause, comprising:
   a first cladding layer in contact with the waveguide; and
   a second cladding layer in contact with the active component,
   wherein:
   the electrically resistive material is between the first cladding layer and the second cladding layer.
Clause 9. The semiconductor structure according to any preceding clause, wherein:
   the waveguide is configured for propagation of a given wavelength of light therein along the light propagation axis; and
   a length of the electrically resistive material along the light propagation axis is equal to an odd integer multiplied by a quarter of the given wavelength of light.
Clause 10. The semiconductor structure according to any one of the preceding clauses, wherein:
   the active component is a photodetector.
Clause 11. The semiconductor structure according to any one of the preceding clauses, wherein:
   the electrically resistive material is a dielectric material.
Clause 12. The semiconductor structure according to any one of the preceding clauses, wherein:
   the waveguide comprises a tapered portion in contact with the electrically resistive material; and
   a width of the tapered portion in a direction perpendicular to the light propagation axis is progressively greater at positions further away from the electrically resistive material.
Clause 13. The semiconductor structure according to clause 12, wherein the width of the tapered portion at a position closest to the electrically resistive material is less than 400 nanometres.
Clause 14. The semiconductor structure according to any previous clause, wherein at least one of the waveguide and the active component comprises a facet at least partially in contact with the electrically resistive material.
Clause 15. The semiconductor structure according to clause 14, wherein the facet intersects the light propagation axis at a non-perpendicular angle.
Clause 16. The semiconductor structure according to clause 14 or 15, wherein the facet is convex.
Clause 17. The semiconductor structure according to clause 14 or 15, wherein the facet is concave.
Clause 18. The semiconductor structure according to any of clauses 14 to 17, wherein the waveguide is a first waveguide, and the active component is in contact with a second waveguide disposed between the electrically resistive material and the active component, and comprising the facet.
Clause 19. The semiconductor structure according to clause 18, wherein the second waveguide comprises a second tapered portion, a width of the second tapered portion in a direction perpendicular to the light propagation axis being progressively greater at positions further away from the active component.
Clause 20. The semiconductor structure according to clause 19, wherein the second waveguide has a width in a direction perpendicular to the light propagation axis greater than a width of the first waveguide in the direction perpendicular to the light propagation axis.
Clause 21. The semiconductor structure according to any one of clauses 14 to 20, wherein the facet comprises a periodic structure configured as an anti-reflective grating.
Clause 22. The semiconductor structure according to clause 21, wherein the periodic structure has a pitch of less than 500 nm.
Clause 23. The semiconductor structure according to any one of clauses 14 to 22, further comprising an absorber element arranged to absorb light reflected from the facet.
Clause 24. The semiconductor structure according to any previous clause, wherein the electrically resistive material is air.
Clause 25. A method of manufacturing a semiconductor structure for a photonic integrated circuit, the method comprising:
   at least partly forming a waveguide and an active component on a substrate, wherein a contact side of the waveguide is in contact with the active component;
   removing a portion of at least one of the waveguide or the active component; and
   depositing an electrically resistive material in a space formed by the removing the portion of at least one of the waveguide or the active component, wherein the electrically resistive material has a resistivity higher than the waveguide.
Clause 26. The method according to clause 25, comprising:
   at least partly forming an intermediate layer on the substrate;
   at least partly forming the waveguide and the active component on the intermediate layer;
   removing a first portion of the intermediate layer in contact with the portion of at least one of the waveguide or the active component; and
   depositing the electrically resistive material in a space formed by the removing of the first portion of the intermediate layer.
Clause 27. The method according to clause 26, comprising:
   removing material overlaid on a second portion of the intermediate layer to expose intermediate layer material; and
   forming an electrical connection with the exposed intermediate layer material.
Clause 28. The method according to any one of clauses 25 to 27, comprising:
   removing a portion of the substrate overlaid by the portion of the at least one of the waveguide or the active component; and
   depositing the electrically resistive material in a space formed by the removing the portion of the substrate.
Clause 29. The method according to any one of clauses 25 to 28, comprising:
   at least partly forming a cladding layer on the waveguide and the active component;
   removing a portion of the cladding layer in contact with the portion of the at least one of the waveguide or the active component; and
   depositing the electrically resistive material in a space formed by the removing the portion of the cladding layer.
Clause 30. The method according to any one of clauses 25 to 29, comprising:
   removing material from the waveguide to form a tapered portion for reducing a refractive index mismatch for light propagating from the waveguide into the electrically resistive material.
Clause 31. A semiconductor structure according to any of clauses 1 to 24, wherein:
   a first side of the electrically resistive material in contact with the active component is at a non-zero angle relative to a second side of the electrically resistive material in contact with the waveguide.
Clause 32. The semiconductor structure according to any of clauses 1 to 24, or 31, wherein:
   the electrically resistive material is in contact with the active component.
Clause 33. A photonic integrated circuit comprising the semiconductor structure according to any one of clauses 1 to 24, or 31, or 32.

## Claims

1. A semiconductor structure for a photonic integrated circuit, the semiconductor structure comprising:
a substrate,
and, on the substrate:
a first waveguide, and an electrically-conductive first layer in contact with the first waveguide and between the substrate and the waveguide;
a second waveguide, and an electrically-conductive second layer in contact with the second waveguide and between the substrate and the waveguide;
an active component optically coupled to the second waveguide; and
an electrically resistive material having an electrical resistivity higher than the first waveguide and being arranged:
(i) between the first waveguide and the second waveguide along a light propagation axis between the first waveguide and the second waveguide, and
(ii) between the electrically-conductive first layer and the electrically-conductive second layer,
to thereby inhibit flow of electricity between the first electrically-conductive layer and the active component;
wherein at least one of the first waveguide and the second waveguide comprise a respective facet in contact with the electrically resistive material and intersecting the light propagation axis non-perpendicularly.

2. The semiconductor structure according to claim 1, wherein the electrically resistive material is air or silicon nitride.

3. The semiconductor structure according to claim 1 or 2, wherein the first waveguide comprises an identical material composition to the second waveguide.

4. The semiconductor structure according to any preceding claim, wherein the electrically-conductive first layer and the electrically conductive second layer are formed of a same doped semiconductor material.

5. The semiconductor structure according to any one of claims 1 to 4, wherein the first waveguide comprises a first facet in contact with the electrically resistive material and intersecting the light propagation axis non-perpendicularly, the second waveguide comprises a second facet in contact with the electrically resistive material and intersecting the light propagation axis non-perpendicularly, the first facet non-parallel with the second facet.

6. The semiconductor structure according to any one of claims 1 to 4, wherein the first waveguide comprises a first facet in contact with the electrically resistive material and intersecting the light propagation axis non-perpendicularly, the second waveguide comprises a second facet in contact with the electrically resistive material and intersecting the light propagation axis non-perpendicularly, the first facet parallel with the second facet.

7. The semiconductor structure according to any of claims 1 to 4, wherein the respective facet is convex.

8. The semiconductor structure according to any one of claims 1 to 4, wherein the respective facet is concave.

9. The semiconductor structure according to any preceding claim, wherein the second waveguide comprises a tapered portion, a width of the tapered portion in a direction perpendicular to the light propagation axis being progressively greater at positions further away from the active component.

10. The semiconductor structure according to claim 9, wherein the second waveguide has a width in a direction perpendicular to the light propagation axis greater than a width of the first waveguide in the direction perpendicular to the light propagation axis.

11. The semiconductor structure according to any preceding claim, wherein the facet comprises a periodic structure configured as an anti-reflective grating.

12. The semiconductor structure according to any preceding claim, further comprising an absorber element arranged to absorb light reflected from the facet.

13. The semiconductor structure according to claim 12, wherein the absorber element is formed from a stack of semiconductor layers suitable for use as a photodetector.

14. The semiconductor structure according to any preceding claim, comprising:
a first cladding layer in contact with the first waveguide; and
a second cladding layer in contact with the second waveguide,
wherein:
the electrically resistive material is between the first cladding layer and the second cladding layer.

15. A photonic integrated circuit comprising the semiconductor structure according to any one of claims 1 to 14.
